# EUROPEAN PATENT SPECIFICATION

(11) **EP 3 092 325 B1**
(45) Date of publication and mention of the grant of the patent: **22.05.2024**
(21) Application number: 15703804.3
(22) Date of filing: 07.01.2015
(51) Int. Cl.: C23C 14/08, H01M 4/04, H01M 10/052, H01M 4/131, H01M 4/1391, H01M 4/485, H01M 4/505, H01M 4/525

(54) **VAPOUR DEPOSITION METHOD FOR PREPARING CRYSTALLINE LITHIUM-CONTAINING COMPOUNDS**
DAMPFABSCHEIDUNGSVERFAHREN ZUR HERSTELLUNG VON KRISTALLINEN LITHIUMHALTIGEN VERBINDUNGEN
PROCÉDÉ DE DÉPÔT EN PHASE VAPEUR POUR PRÉPARER DES COMPOSÉS CONTENANT DU LITHIUM CRISTALLINS

(30) Priority: 08.01.2014 GB 201400277
(43) Date of publication of application: 16.11.2016
(73) Proprietor: Ilika Technologies Limited, Romsey SO51 9DL (GB)
(72) Inventor: SMITH, Duncan Clifford Alan, Southampton Hampshire SO16 7NS (GB); HAYDEN, Brian Elliott, Southampton Hampshire SO16 7NS (GB); PERKINS, Laura Mary, Southampton Hampshire SO16 7NS (GB); LEE, Christopher Edward, Southampton Hampshire SO16 7NS (GB); ANASTASOPOULOS, Alexandros, Southampton Hampshire SO16 7NS (GB); HUTCHINGS, Kyle James, Southampton Hampshire SO16 7NS (GB); YAKOVLEV, Sergey, Southampton Hampshire SO16 7NS (GB)
(74) Representative: Murgitroyd & Company
(86) International application number: PCT/GB2015/050014
(87) International publication number: WO 2015/104539

(56) References cited:
- WO-A2-2013/011327
- JP-A- H04 187 759
- US-A- 5 016 563
- US-A- 5 128 007
- US-A1- 2004 058 237
- US-A1- 2013 189 588
- US-B1- 6 982 132

## Description

### BACKGROUND OF THE INVENTION

The present invention relates to a method for preparing crystalline lithium-containing compounds, particularly transition metal oxides, by vapour deposition.

The deposition of materials in thin film form is of great interest owing to the many applications of thin films, and a range of different deposition techniques are known. Various of the techniques are more or less suitable for particular materials, and the quality, composition and properties of the thin film produced typically depends greatly on the process used for its formation. Consequently, much research is devoted to developing deposition processes that can produce thin films appropriate for specific applications.

An important application of thin film materials is in solid state thin film cells or batteries, such as lithium ion cells. Such batteries are composed of at least three components. Two active electrodes (the anode and the cathode) are separated by an electrolyte. Each of these components is formed as a thin film, deposited in sequence on a supporting substrate. Additional components such as current collectors, interface modifiers and encapsulations may also be provided. In manufacture, the components may be deposited in the order of cathode current collector, cathode, electrolyte, anode, anode current collector and encapsulation, for example.

In the lithium ion example, the anode and the cathode are capable of reversibly storing lithium. Other requirements of the anode and cathode materials are high gravimetric and volumetric storage capacities which can be achieved from a low mass and volume of material, while the number of lithium ions stored per unit should be as high as possible. The materials should also exhibit acceptable electronic and ionic conduction so that ions and electrons can move through the electrodes during the battery charge and discharge process.

Otherwise, the anode, cathode and electrolyte require different properties. The cathode should present reversible lithium intercalation at high potentials, while the anode should present reversible lithium intercalation at low potentials.

The electrolyte physically separates the anode and cathode, so it must have extremely low electrical conductivity to prevent short circuiting of the battery. However, to enable reasonable charge and discharge properties the ionic conductivity of the material must be as high as possible. Furthermore the material must be stable during the cycling process and not react with either the cathode or the anode.

The manufacture of solid state batteries poses a range of challenges. In particular, reliable and efficient techniques for producing materials suitable for use as cathodes are of great interest. For many popular cathode materials, the cathode layer of the battery is required to have a crystalline structure to provide the required properties outlined above. However, depositing a quality crystalline cathode layer in a way which is compatible with subsequent steps in the manufacturing and processing of the complete battery is often problematic.

Many different methods of depositing the components of thin film batteries are known, e.g. from US 5 128 007 A. Synthetic routes to thin films, which are generally referred to using the umbrella term of 'physical vapour deposition' include: pulsed laser deposition (Tang, S.B., et al., J. Solid State Chem., 179(12), (2006), 3831-3838), flash evaporation (Julien, C.M. and G.A. Nazri, Chapter 4. Materials for electrolyte: Thin Films, in Solid State Batteries: Materials Design and Optimization (1994)), sputtering and thermal evaporation.

Of these sputtering is the most widespread deposition technique. In this method a target of a particular composition is sputtered using plasma formed over the target and the resulting vapour condenses on a substrate to form the thin film. Sputtering involves the deposition of materials directly from a target. The product of the sputter varies and may include dimers, trimers or higher order particles (Thornton, J.A. and J.E. Greene, Sputter Deposition Processes, in Handbook of Deposition Technologies for films and coatings, R.F. Bunshah, Editor 1994, Noyes Publications). The deposition rate, composition, morphology, crystallinity and performance of thin films are determined by a complex relationship with the sputtering parameters used.

Sputtering can be disadvantageous in that it is difficult to predict the effect of the various sputtering parameters on the characteristics and performance of the deposited material. In part this is due to the confounding effect of multiple deposition parameters on film characteristics. The deposition rate, composition, morphology, crystallinity and performance of sputtered thin films are determined by a complex relationship with the sputtering parameters used. Hence, it can be very difficult to alter the individual parameters of the sputtered film (for example, concentration of a single element, deposition rate or crystallinity) without affecting other properties of the film. This results in difficulties in achieving a composition of interest, which makes optimisation of the film and therefore of the properties of any intended battery or other thin film device extremely problematic.

The technique of pulsed laser deposition (PLD) shares many properties with sputtering, due to the use of a compositionally unique target and the use of high energies. However, this route tends to yield rough samples, which is also a problem with sputtering. The surface morphology of LiMn_{1.5}Ni_{0.5}O₄ thin films prepared by PLD has been noted to be rough, with formation of grains with sizes from 30 nm upwards dependent on the temperature of the deposition (Wang et al. Electrochimica Acta 102 (2013) 416-422). Surface roughness is highly undesirable in layered thin film structures such as a solid state battery, where any large protruding features could extend well into, or even through, an adjacent layer.

Deposition of thin films from thermal evaporation of compound sources has been demonstrated in the synthesis of battery components for materials such as LiMn₂O₄ (LMO, lithium manganese oxide) and B₂O₃-Li₂O (Julien, C.M. and G.A. Nazri, Chapter 4. Materials for electrolyte: Thin Films, in Solid State Batteries: Materials Design and Optimization (1994)). In this instance the particle energies are much lower than those encountered in sputtering, which can inhibit cluster formation, reduce surface roughness and provide smooth, undamaged surfaces. However, problems such as variation in composition between source and resultant thin film are common to all routes which begin with compound evaporation targets (sputtering, PLD). Furthermore it has been noted that a relationship between substrate temperature and the composition of the deposited film exists once again resulting in difficulties in optimising material performance due to a confounding of parameters.

An alternative is thermal evaporation directly from the elements, but this is uncommon. Julien and Nazri (Chapter 4. Materials for electrolyte: Thin Films, in Solid State Batteries: Materials Design and Optimization (1994)) allude to an attempt to synthesize B₂O₃-xLi₂O-yLiₙX (X = I, Cl, SO₄ and n = 1,2) directly from the elements, but no results are reported and the authors comment that "the difficulties in implementing this technique stay in enhancing the oxygen pumping, avoiding the high oxygen reactivity with the heated parts of the system, and making available an oxygen monoatomic source in order to enhance oxygen reactions on the surface".

State of the art cathode materials such as LiMn₂O₄ (LMO) and LiMn_{1.5}Ni_{0.5}O₄ (LMNO) are required to be in the crystalline state to achieve optimum ionic conductivity. This can be achieved by either a low temperature deposition followed by post annealing, or depositing at high substrate temperatures. Cathodes deposited at low substrate temperatures (below 250°C) are often insufficiently crystalline, resulting in reduced performance. Therefore, a further crystallisation step is required, this is typically achieved by a post-deposition, high temperature anneal, although this step can result in a lithium deficiency in the film (Singh et al. J. Power Sources 97-98 (2001), 826-831). Samples of LMO deposited by RF-sputtering on to a heated substrate have been found to have an initial crystallization temperature of 250°C, while films grown using a substrate temperature below 200°C exhibited a broad and diffuse XRD pattern, consistent with materials that are X-ray amorphous (Jayanth et al. Appl Nanosci. (2012) 2:401-407).

Crystalline LiNi_{0.5}Mn_{1.5}O₄ (LMNO) thin films have been deposited using PLD at higher substrate temperatures, between 550 and 750 °C followed by a post anneal for one hour at the same temperature (Wang et al. Electrochimica Acta 102 (2013) 416-422). Using high substrate temperatures such as these has certain disadvantages. Loss of lithium is more significant at higher temperatures, and there is the possibility of cross contamination due to diffusion of materials between the deposited film and the substrate, which limits the possible substrates available for use.

Previously, the present inventors have demonstrated the synthesis of phosphorous-containing materials, suitable for some thin film battery components, directly from the constituent elements (WO 2013/011326; WO 2013/011327). However, a complexity in this process is the use of a cracker to break down phosphorous so as to enable the formation of phosphates. The synthesis of cathode (lithium iron phosphate (LFP) - example 5, lithium manganese phosphate (LMP)- example 7) and electrolyte materials (Li₃PO₄ - example 1 and nitrogen doped Li₃PO₄ - example 6) is disclosed. The deposited materials are amorphous, so annealing is used to crystallise the cathode materials, at temperatures of 500°C and 600°C for LFP and LMP respectively. Although this work demonstrates two of the three basic building blocks for producing a thin film cell, it does not demonstrate an operational cell.

The process of annealing, which involves exposing a material to a high temperature to crystallise it, is potentially applicable whenever a deposited material is insufficiently crystalline. The temperature required will depend on the material, but is typically at least 500°C and may be significantly higher, and the resulting crystalline layer may be of poor quality. As an example, the cathode material lithium manganese nickel oxide (LMNO; LiMn_{1.5}Ni_{0.5}O₄) has been crystallised by annealing sputtered thin films, but the resulting layers are polycrystalline and composed of grains with diameters between 50-150 nm. The films have also been shown to contain a number of impurity phases (Baggetto et al., J Power Sources 211 (2012) 108-118).

Also, annealing is an undesirable complexity in itself, and it complicates the manufacture of a complete battery or other layered device. As discussed, solid state batteries based on state of the art materials require crystalline electrodes (such as LiCoO₂, LiMnO₄, LiMn_{1.5}Ni_{0.5}O₄), and amorphous electrolytes (such as LiPON). This requirement means it has generally been necessary to anneal the electrode prior to the deposition of the electrolyte layer, to avoid crystallisation of the electrolyte. This step requires both time and energy to provide sufficient crystallisation. Furthermore, one or more high temperature processing steps (e.g. LiMn_{1.5}Ni_{0.5}O₄: 550-750°C for PLD (Wang, Y., et al., Electrochimica Acta, (2013), 102(0), 416-422) and multiple anneals at 750-800°C for sol-gel and solid state synthesis (Zhong, Q., et al., J. Electrochem. Soc., (1997), 144(1), 205-213) are typically required, thereby limiting components such as the substrate to those compatible with such high temperature processing. Additionally such a process prevents the deposition of stacked cells by sequential means, since any electrolyte already deposited must also be annealed, causing crystallisation. Such crystallisation is known to cause a dramatic reduction in the ionic conductivity of the state of the art electrolyte, LiPON. The conductivity of crystalline LiPON is known to be seven orders of magnitude lower than that of the amorphous material (Bates et al. Synthesis, Crystal Structure, and Ionic Conductivity of a Polycrystalline Lithium Phosphorus Oxynitride with the γ-Li3PO4 Structure. Journal of Solid State Chemistry 1995, 115, (2), 313-323). Further problems associated with such high temperature processing include delamination and cracking of individual layers.

Techniques have been proposed to address these problems. For example, it has been shown that by providing a focused beam of ions it is possible to deposit crystalline films in-situ (WO 2001/73883). In this case adatoms (defined in this case as a particle, molecule or ion of material that has not yet been formed into a structure or film) of a cathode material were deposited onto the substrate while a second flux of ions supplied energy to the cathode material. A flux of the second material provided energy (5 - 3000 eV) adjacent to the first material to assist in the growth of a desirable crystalline material. This has been demonstrated for LiCoO₂ as a cathode. In the case of LiCoO₂ a beam of O₂ ions was utilized in room temperature deposition. This beam of oxygen is noted to have two functions, both controlling the crystallization and the stoichiometry of LiCoO₂ (EP 1,305,838). The beam of ions addresses three problems encountered in the preparation of thin films - that of compositional control, preparation of dense films and crystallisation of the resultant films. However, the ion beam is a complicating aspect of the process.

Therefore, there is a need for an improved and simplified method of depositing crystalline materials suitable for use as electrodes in thin film batteries. Improvements can better the materials per se so as to enhance the overall performance of batteries, and can also enable better manufacture of layered thin film structures.

### SUMMARY OF THE INVENTION

Accordingly, a first aspect of the present invention is directed to a vapour deposition method according to claim 1.

This provides a very simple method for forming lithium-containing transition metal oxide compounds, in which the compounds produced are crystalline and therefore directly suitable for applications such as thin film battery electrodes without any post-processing needed to develop the crystalline state. The deposition of each component element directly from its own vapour source allows close control of the flux of each element so that the stoichiometry of the deposited compound can be precisely tailored. This is an improvement over known techniques such as pulsed laser deposition (PLD) and sputtering, which do not allow such control. This advantage is particularly significant when depositing for extended periods. If drift occurs within the deposition rates of any elements deposited from the vapour sources of the invention, this can easily be accommodated by modifying the relevant source temperatures. Such a drift cannot be so easily accommodated in a PLD or sputtering system since the deposition is from a compound target.

There are other advantages. The deposition of the material directly in the crystalline form reduces processing complexity compared to known deposition techniques that require post-annealing or an ion beam to produce crystallisation. For example, methods of the present invention simplify the known synthesis method described in EP1,305,838 by removing the requirement for a secondary source to provide energised material at a site adjacent to the location of deposition. Instead, increasing the substrate temperature from 25°C to about 150°C causes the crystallisation. The change in substrate energy for this temperature increase is approximately 0.01 eV. The inventors have noted that the crystallisation behaviour under the invention is not altered if ion deflection plates are utilised in line with the oxygen source (for example an oxygen plasma source), which reduces the ion content of the beam below 0.1%. From this it is clear that the crystallisation is not caused by ions or other charged particles in the vapour; rather it is caused by the heating of the substrate. So, the energy required to crystallise the oxide material is provided by moderate heating of the substrate during deposition, both saving time and allowing a simpler apparatus. Also, the energies of evaporated particles from vapour sources are significantly lower than the particle energies encountered in known techniques such as sputtering, and the lower energy of the particles prevents cluster formation, reduces roughness and provides smooth, undamaged surfaces. While clearly of general benefit, this advantage is critical when depositing layers of material within devices which may be composed of thin films with thicknesses less than 1 µm. Thus, high quality thin films with precise physical and chemical structure can be produced by use of the invention.

The vapour source of oxygen is a vapour source of atomic oxygen, that is, an ozone source or a plasma source. Atomic oxygen is advantageous where other component elements are required in the compound in a high oxidation state.

The temperature range overall is very much lower than the temperatures required for producing crystalline material by known techniques such annealing. This can save energy and hence reduce cost, and also enhances safety. Also, the convenient range of moderate temperatures at which the method can be carried out allows selection of a temperature that fits with possible other processing steps, and enables choice of a particular amount of crystallinity, since crystal size can be enlarged by increasing the substrate temperature. For example, the method may comprise heating the substrate to between 150°C and 250°C, or to between 250°C and 350°C, or to between 200°C and 300°C or according to claim 1 between 150°C and 450°C.

In an embodiment, the source or sources of one or more transition metals may comprise a source of manganese, so that the crystalline compound is lithium manganese oxide. With this material, the method may comprise heating the substrate to substantially 225°C, for example, although both lower and higher temperatures, for example in the ranges set out above, will produce good quality lithium manganese oxide.

In an alternative embodiment, the source or sources of one or more transition metals may comprise a source of manganese and a source of nickel, so that the crystalline compound is lithium manganese nickel oxide. Then, the method may comprise heating the substrate to substantially 350°C, for example, although lower temperatures, for example in the ranges set out above will also produce good quality lithium manganese nickel oxide.

Embodiments of the invention may be implemented with other transition metals. Transition metals of particular interest for use in electrodes are cobalt, nickel, manganese, iron, vanadium, molybdenum, titanium, copper and zinc.

The vapour sources may further comprise a source of nitrogen, if an oxy-nitride or nitrogen-doped crystalline material is desired.

Co-depositing the component elements onto the heated substrate may comprise co-depositing the component elements directly onto a surface of the heated substrate. Alternatively, co-depositing the component elements onto the heated substrate may comprise co-depositing the component elements onto one or more layers supported on the substrate. Thus the method is flexible, and allows a compound to be formed as a separate sample, or as a layer within a layered structure such as a thin film device.

A second aspect of the present invention is directed to a method of making a battery, comprising depositing an electrode of the battery as a layer of a crystalline lithium-containing transition metal oxide compound using a vapour deposition method according to the first aspect of the invention.

Other aspects of the invention are directed to a battery comprising an electrode in the form of a layer of a crystalline lithium-containing transition metal oxide compound deposited using a vapour deposition method according to the first aspect of the invention, and an electronic device comprising a battery having an electrode in the form of a layer of a crystalline lithium-containing transition metal oxide compound deposited using a vapour deposition method according to the first aspect of the invention. According to the second and other aspects, the electrode may be a cathode. Alternatively, the electrode may be an anode, for example comprising lithium titanium oxide (LTO, Li₄Ti₅O₁₂).

A further aspect of the invention is directed to a sample of a crystalline lithium-containing transition metal oxide compound deposited on a substrate using a vapour deposition method according to the first aspect of the invention.

### BRIEF DESCRIPTION OF THE DRAWINGS

For a better understanding of the invention and to show how the same may be carried into effect reference is now made by way of example to the accompanying drawings in which:
Figure 1 shows a schematic representation of an example apparatus suitable for implementing a method according to embodiments of the invention;
Figure 2 shows X-ray diffraction measurements of samples of lithium manganese oxide deposited by methods according to embodiments of the invention;
Figure 3 shows X-ray diffraction measurements of samples of lithium manganese nickel oxide deposited by methods according to embodiments of the invention;
Figure 4 shows scanning electron microscope images of the surface of samples of lithium manganese oxide deposited by a method according to an embodiment of the invention compared with images of the surfaces of samples prepared by a prior art method;
Figure 5 shows scanning electron microscope images of the surface of samples of lithium manganese nickel oxide deposited by a method according to an embodiment of the invention compared with images of the surfaces of samples prepared by a prior art method;
Figure 6 shows a schematic cross-sectional view of an example thin film battery of conventional structure;
Figure 7 shows discharge curves measured from half cells comprising lithium manganese oxide deposited by a method according to an embodiment of the invention;
Figure 8 shows capacity measurements taken from samples of lithium manganese oxide deposited by a method according to an embodiment of the invention, at various discharge rates;
Figure 9 shows discharge curves measured from batteries having a lithium manganese oxide cathode deposited by a method according to an embodiment of the invention;
Figure 10 shows a graph of discharge capacities measured over 50 cycles of one battery having a lithium manganese oxide cathode deposited by a method according to an embodiment of the invention;
Figure 11 shows a measurement of cyclic voltammetry from a half cell having a lithium manganese nickel oxide cathode deposited by a method according to an embodiment of the invention;
Figure 12 shows a discharge curve measured from the cell featured in Figure 11;
Figure 13 shows discharge curves measured from batteries having a lithium manganese nickel oxide cathode deposited by a method according to an embodiment of the invention;
Figure 14 shows an X-ray diffraction measurement of a sample of lithium manganese oxide deposited at an increased rate by a method according to an embodiment of the invention;
Figure 15 shows a scanning electron microscope image of the surface of a sample of lithium manganese oxide deposited at an increased rate by a method according to an embodiment of the invention; and
Figure 16 shows a measurement of cyclic voltammetry from a half cell having a lithium manganese oxide cathode deposited at an increased rate by a method according to an embodiment of the invention.

### DETAILED DESCRIPTION

The present invention provides a method for forming samples, including thin films, of crystalline lithium-containing transition metal oxide compounds (without phosphorous), by vapour deposition. Each component element of the compound is provided separately as a vapour from a respective source, and the component atomic element vapours are co-deposited onto a common heated substrate. The component elements react on the substrate to form the compound.

In the context of this disclosure, the term "element" means "element of the periodic table". The compounds formed according to the invention therefore comprise component elements including lithium (Li), oxygen (O), and one or more transition metals. Other component elements will depend on the particular compound being formed, but in all cases each element in the compound is provided separately in the form of a vapour (or possibly combined into a mixed vapour or plasma if appropriate), and each vapour deposits onto a common substrate.

Also in the context of this disclosure, the term "lithium-containing transition metal oxide compound" means "a compound containing lithium, oxygen, one or more transition metals, and possibly one or more other elements", where "a compound" is "a substance or material formed by the combination of two or more elements in fixed proportions by a chemical reaction".

In the context of this disclosure, the term "crystalline" means "a solid that has a regular internal arrangements of atoms, ions or molecules characteristic of crystals", i.e. that has a long range order in its lattice. It has been found that, according to the methods of the present invention, a desired compound can be deposited in crystalline form at the described moderate temperatures when one or more of the component elements from which the compound is deposited is a transition metal element. In the context of this disclosure, a "transition metal" means "any element in the d-block of the periodic table, being groups 3 to 12 on the periodic table, plus any element in the f-block lanthanide and actinide series (also known as "inner transition metals")". Transition metals with an atomic number of 72 or below are of particular interest, owing to their smaller size and weight; these are scandium, titanium, vanadium, chromium, manganese, iron, cobalt, nickel, copper, zinc, yttrium, zirconium, niobium, molybdenum, technetium, ruthenium, rhodium, palladium, silver, cadmium, lutetium and hafnium, especially cobalt, nickel, manganese, iron, vanadium, molybdenum, titanium, copper and zinc for use in materials intended as electrodes. However, heavier transition metals such as tantalum, tungsten, rhenium, osmium, iridium, platinum, gold, mercury, and beyond are not precluded.

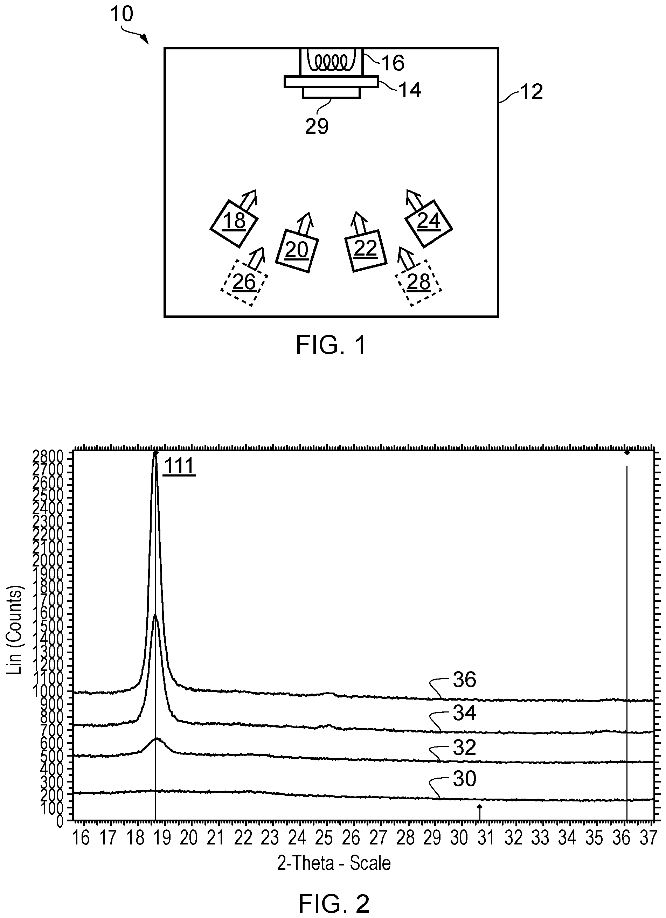

Figure 1 shows a schematic representation of an example apparatus 10 suitable for implementing an embodiment method of the invention. The deposition is carried out within a vacuum system 12, which may be an ultrahigh vacuum system. A substrate 14 of a desired material (depending on the intended purpose of the deposited crystalline compound) is mounted within the vacuum system 12, and heated above room temperature using a heater 16. The temperature is discussed further below. Also within the vacuum system are a plurality of vapour sources, one source for each of the component elements in the desired thin film compound. A first vapour source 18 comprises a source of atomic oxygen, such as an oxygen plasma source. A second vapour source 20 comprises a source of lithium vapour. A third vapour source 22 comprises a source of vapour of a transition metal element. Fourth vapour source 24 may comprise a source of a further transition metal element, depending on the component elements of the desired compound. Any number of other vapour sources (such as 26, 28, shown in phantom) may optionally be included depending on the number of elements comprised in the compound material of interest. For example, a source of nitrogen may be included if the compound is to be an oxynitride or doped with nitrogen. Nitrogen may also be provided by introducing it through an oxygen plasma source to deliver a mixed nitrogen-oxygen plasma. None of the vapour sources provides phosphorous, however.

The nature of each vapour source will depend on the element it delivers, and also the amount of control required over the rate of delivery, or flux. A source may be a plasma source, for example, particularly in the case of the oxygen vapour source. A plasma source delivers plasma-phase oxygen, i.e. a flux of oxygen atoms, radicals and ions. The source may be a radio frequency (RF) plasma source, for example. Atomic oxygen is advantageous when depositing compounds that comprise elements in high oxidation states. Oxygen may alternatively be provided using an ozone source. A plasma source such as an RF plasma source may also be used to deliver nitrogen, if a nitrogen-containing compound is to be formed. For example, the lithium-containing transition metal oxide compound may be an oxynitride.

Electron beam evaporators and Knudsen cells (K-Cells) are other examples of vapour sources; these are well-suited for materials with low partial pressures. In both cases the material is held in a crucible and heated to generate a flux of material. A Knudsen cell uses a series of heating filaments around the crucible, whereas in an electron beam evaporator the heating is achieved by using magnets to direct a beam of high energy electrons onto the material.

Other example vapour sources are effusion cells and cracking sources. Embodiments of the invention eliminate any need for cracking, however, and thereby avoid the complexity inherent in the use of such sources. Further alternative vapour sources will be evident to the skilled person.

During the deposition process, a controlled flux of each component element is released from its respective vapour source 18-28 onto the heated substrate 14, whereupon the various elements are co-deposited. The elements react on the substrate 14 to form a thin film layer 29 of the crystalline lithium-containing transition metal oxide compound.

The reaction of the component elements to form the compound occurs on the surface of the substrate rather than in the vapour phase prior to deposition on the substrate. While not wishing to be bound by theory, it is believed that each component element in the vapour form collides with and adheres to the surface of the heated substrate, where the atoms of each element are then mobile on the surface and so are able to react with each other to form the oxide compound.

Performing the process in a vacuum ensures that the mean free path of the vapour phase particles (mean distance travelled before collision with another particle) travelling in the vacuum from their respective sources is long so that the chance of collisions between particles prior to deposition on the substrate is minimised. Advantageously, therefore, the distance from the sources to the substrate is arranged to be less than the mean free path to increase the chance of the particles reaching the substrate without colliding, thereby avoiding vapour phase interactions. Reaction of the component elements is hence limited to the heated substrate surface and the quality of the thin film compound material is enhanced.

A significant advantage of the invention is that deposition of the constituents of the compound directly from the elements allows for direct control of the compound composition via the rates of deposition of the component elements. The flux of each element can be independently controlled by appropriate operation of its respective vapour source so that the chemical composition of the deposited compound can be tailored according to exacting requirements if desired. Direct control of the stoichiometry of the deposited compound is therefore possible by controlling the flux, and hence consequently the rate of deposition, of each component element. Conventional deposition techniques such as sputtering and pulsed laser deposition can suffer from preferential loss of lighter elements so control of the proportion of the elements in the final compound is more difficult; the present invention alleviates this difficulty since elements likely to suffer greater loss can be delivered at an increased rate to compensate. Higher quality material can thereby be deposited.

Also, deposition directly from the component elements eliminates the need for sputtering targets or precursors, and additional elements can be incorporated directly with no requirement to prepare new deposition targets. Further, it enables the deposition of smooth dense films with undamaged surfaces. Vapour sources such as those exemplified above produce lower energy particles than those produced by sputtering; this lower energy prevents cluster formation and reduces surface roughness of the deposited thin film, which is also a problem with pulsed laser deposition.

Importantly, the invention allows the direct deposition of crystalline lithium-rich transition metal oxides. The crystalline character makes the compounds suitable for use as electrodes, particularly cathodes, in thin film batteries. Under conventional synthetic conditions for both bulk and thin film samples, a post-deposition annealing step is typically needed to crystallise the material, which both complicates the process and is incompatible with any already-deposited material which needs to remain amorphous. The present invention is thus beneficial in offering a technique for making lithium-based thin film cathodes.

A feature of the invention is a moderate heating of the substrate. Prior work by the inventors (WO 2013/011326, WO 2013/011327) showing the synthesis of amorphous phosphorous-containing thin film materials by direct deposition of the constituent elements onto a substrate at room temperature suggested that the technique might be possible for other materials. However, the technique produced amorphous materials only, and a separate annealing step at temperatures in the range 350°C to 750°C was required to produce crystalline cathode materials.

The change of state from amorphous to crystalline at high temperatures is well-known, and deliberately employed in the process of annealing to make crystalline materials by heating amorphous materials. Very high temperatures are typically required, and the additional separate step adds complexity. As an alternative, crystallisation can sometimes be encouraged by heating the substrate during deposition, but again, very high temperatures are required. For example, crystalline LiNi_{0.5}Mn_{1.5}O₄ (LMNO) thin films have been deposited using PLD at substrate temperatures between 550°C and 750°C, but a subsequent anneal for one hour at the same temperature was still required (Wang et al. Electrochimica Acta 102 (2013) 416-422). Moreover, the use of PLD caused considerable surface roughness of the thin films.

Consequently, it is a surprising and unexpected result that samples of crystalline lithium-containing transition metal oxides can be successfully fabricated by depositing vapour phase component elements directly onto a moderately heated substrate. "Moderate" in this context is a temperature range of between about 150°C and 450°C. These temperatures are much lower than the temperatures required to produce crystallisation by annealing, and also much lower than substrate temperatures reported to date which have been used to encourage crystallisation during deposition by other techniques. Providing component elements including lithium, oxygen and one or more transition metals and heating the substrate to between about 150°C and 450°C has been found to create the necessary conditions for the component elements to successfully react on the substrate surface to form the compound directly in the crystalline form. Stable, good quality crystalline compounds with useful properties are formed.

### Experimental results

As examples, crystalline lithium manganese oxide and crystalline lithium manganese nickel oxide thin films have been fabricated by methods according to embodiments of the present invention.

Unless otherwise stated the depositions were carried out within an ultra-high vacuum (UHV) system using the arrangement described in Guerin, S; Hayden, B. E., J. Comb. Chem., 2006, 8, 66 and WO 2005/035820. The films were deposited onto sapphire substrates coated with TiO₂ (10 nm) and platinum (100 nm) (AlOPt, from Mir Enterprises).

Lithium manganese oxide and lithium manganese nickel oxide (LMO and LMNO respectively) thin films intended as cathodes were synthesised from lithium, manganese, nickel and oxygen sources. Manganese and lithium were deposited from Knudsen cells. Nickel was deposited from an electron beam evaporator and oxygen was provided by a plasma atom source. Knudsen cells comprise a crucible to contain the material; this is held within a series of heating filaments. As in this example, they are typically used to evaporate materials with low partial pressures. An electron beam evaporator also uses a crucible to contain the material, but instead of applying heat via heating elements a beam of high energy electrons is directed onto the material by a series of magnets. This causes the material to heat, generating a flux of material. Electron beam evaporators are typically used for materials with low partial pressures (e.g. nickel).

A range of samples of LMO were deposited at substrate temperatures between 25°C and 350°C. By modifying the substrate temperature utilised, the threshold for crystallisation could be determined, and crystallisation of the resultant material was enhanced as the temperature was raised.

Figure 2 shows the results of X-ray diffraction measurements of samples of LMO deposited at different temperatures. Line 30 represents LMO deposited at room temperature (25°C), which exhibits no clear peaks in the diffraction patterns. This is consistent with an amorphous material, as expected at for deposition at room temperature. Increasing the substrate temperature to 150°C (line 32) causes crystallization to occur, which can be seen from the fact that the diffraction pattern recorded for this sample exhibits a small peak at ca. 18.6°, consistent with the 111 reflection of LiMn₂O₄ (00-035-0782). The observation of crystallization by X-ray diffraction at a substrate temperature of only 150°C is surprising given the prior art which indicates that deposition of thin films of LMO at temperatures below 200°C results in X-ray amorphous materials (Jayanth et al. Appl Nanosci (2012) 2:401-407). Increasing the substrate temperature further to 250°C (line 34) is noted to further enhance crystallisation, as exhibited by the enhanced peak intensity of the 111 reflection. LMO deposited at 350°C (line 36) exhibits a further enhancement in the peak intensity at the angle. Clearly, heating the substrate to temperatures between those for which data is presented in Figure 2 will also produce a crystalline material, as will somewhat higher substrate temperatures such as up to about 450°C.

Determining the full width at half maximum (FWHM) for these peaks provides further insight into the improved crystallisation. As crystallites grow the FWHM reduces due to the larger crystallites providing enhanced ordering. LMO deposited at 150°C exhibits a FWHM of 0.882°. This can be translated by the Scherrer equation into an approximate crystallite size, which in this case is approximately 9nm. Increasing the deposition temperature to 250°C causes a reduction in the FWHM to 0.583° and a concomitant increase in the crystallite size to 14nm. A further increase in temperature to 350°C results in a FWHM of 0.471° and a crystallite size of 17 nm.

Hence, good quality structured crystalline material is achieved at these modest substrate temperatures. This represents a great improvement over known techniques, both by removing the need for post-annealing, and by reducing the manufacturing temperature compared to that needed for annealing.

Lithium manganese nickel oxide (LMNO) samples were prepared under various conditions using the previously detailed technique. Again, crystalline material was successfully deposited directly at only modest substrate temperatures. By modifying the substrate temperature utilised, the crystallisation of the resultant material can be enhanced.

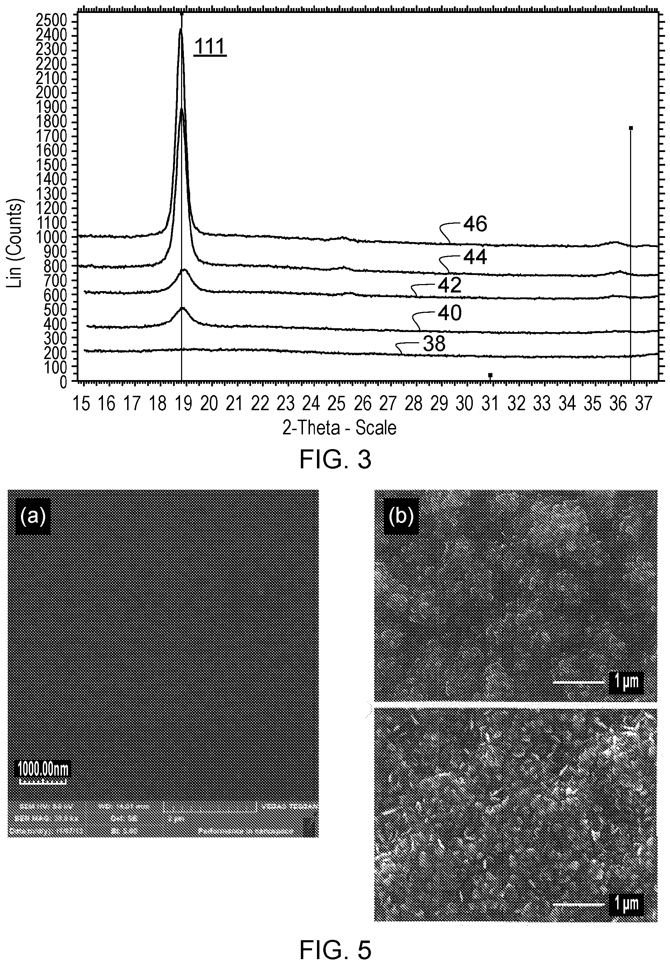

Figure 3 shows the results of X-ray diffraction measurements of samples of LMNO deposited at different temperatures. Material deposited at room temperature (25°C), shown by line 38, exhibits no clear peaks in the diffraction patterns, consistent with the amorphous material expected at this temperature. Increasing the temperature to 150°C (line 40) enhances the crystallisation, and diffraction patterns recorded for this sample exhibits a small peak at ca. 18.6°, consistent with the 111 reflection of LiMn_{1.5}Ni_{0.5}O₄ (04-015-5905). Increasing the substrate temperature further to 250°C (line 42) is noted to further enhance crystallisation, as exhibited by the larger peak intensity of the 111 reflection. Material deposited at 350°C (line 44) exhibits a further enhancement in the peak intensity at the angle, and LMNO deposited at 450°C (line 46) exhibits an additional enhancement in the peak intensity at the angle. Clearly, heating the substrate to temperatures between those for which data is presented in Figure 3 will also produce a crystalline material

Determining the full width at half maximum (FWHM) for these peaks provides further insight into the improved crystallisation. As crystallites grow the FWHM reduces due to the larger crystallites providing enhanced ordering. LMNO deposited at 150°C exhibits a FWHM of 0.841°. This can be translated by the Scherrer equation into an approximate crystallite size, which in this case is approximately 10 nm. Increasing the deposition temperature to 250°C causes a slight reduction in the FWHM to 0.805° resulting in a crystallite size of approximately 10 nm. Further increases in temperature to 350°C results in a FWHM of 0.511° and a crystallite size of 16 nm. Depositions carried out at 450°C exhibit a FWHM of 0.447° and a crystallite size of 18 nm.

So, as for LMO, good quality structured crystalline LMNO can be achieved with these moderate temperature substrates. Indeed, the X-ray diffraction measurements of LMNO clearly demonstrate that it is possible to deposit crystalline LMNO at moderate temperatures significantly lower than those previously demonstrated without any need to post anneal, or apply energy for a secondary source such as an ion source. As a comparison it has been previously shown that the annealing processes required to produce crystalline LMNO with sol-gel samples requires three anneals at 750°C and a further anneal at 800°C (Zhong, Q., et al., J. Electrochem. Soc., (1997), 144(1), 205-213).

### Surface characterisation of the crystalline LMO and LMNO

The surface morphology of LMO and LMNO samples deposited according to embodiments of the present invention has been compared with those deposited by alternative methods, to determine any improvements.

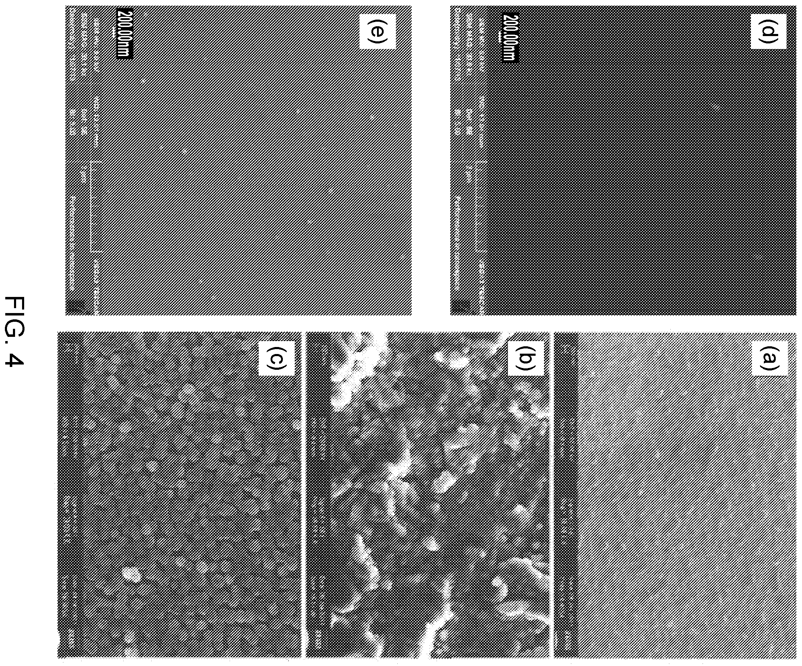

Figures 4(a) - 4(e) show some of the results, in the form of scanning electron microscope (SEM) images at 30 K X magnification. Figures 4(e) and 4(d) show LMO thin films deposited according to the invention at substrate temperatures of 225°C and 350°C respectively, while Figures 4(a), 4(b) and 4(c) show LMO films deposited using RF sputtering at substrate temperatures of 200°C, 300°C and 400°C respectively (Jayanth et al. Appl Nanosci (2012) 2:401-407). Note that LMO deposited according to the invention at both 225°C and 350°C exhibits significantly reduced roughness compared to that deposited by RF sputtering at 200°C and 300°C. Only a very small number of features of around 100 nm in diameter are observed on a LMO film deposited according to the invention at 350°C, and still fewer on the film deposited at 225°C. These samples are significantly smoother than the films deposited by sputtering; for example the film deposited at 300°C can be observed to have features with diameters of the order of 1 µm. The features observed on sputtered films are generally an order of magnitude larger than those observed on films deposited according to embodiments of the invention, and this will make a significant difference when these thin films are assembled into devices. For example, this enhanced film quality is critical when depositing multiple thin layers of films on top of one another. If one were to use LMO as a cathode within a solid state battery it would be necessary to deposit a suitably thick layer of solid electrolyte onto the LMO to prevent direct contact between the LMO and th-e overlying anode caused by surface protrusions extending into and through the electrolyte. An increased smoothness of the LMO layer as can be achieved by use of the present invention will enable a thinner layer of electrolyte to be used, which results in a more efficient solid state battery and cheaper and more efficient manufacture of that battery.

Figures 5(a) and 5(b) show comparative SEM images of LMNO samples. Figure 5(a) shows LMNO deposited according to the invention at 350°C, and Figure 5(b) shows LMNO deposited by magnetron sputtering with a post anneal at 700°C in air (upper image) and 750° in air (lower image) (Baggetto et al., J. Power Sources, (2012), 211, 108-118). As can be seen from these images, the sample fabricated according to the invention exhibits a significantly smoother denser film surface than those of the prior art deposited by sputtering with a post-anneal.

### Further experimental results: LMO deposited at 225°C

Cyclic voltammetry and constant current/constant voltage (CC/CV) measurements of LiMn₂O₄ thin films deposited at a substrate temperature of 225°C and used in either liquid electrolyte half cells or solid state full cells demonstrate that the films produced according to the invention are electrochemically active, with capacities comparable with those demonstrated in the literature.

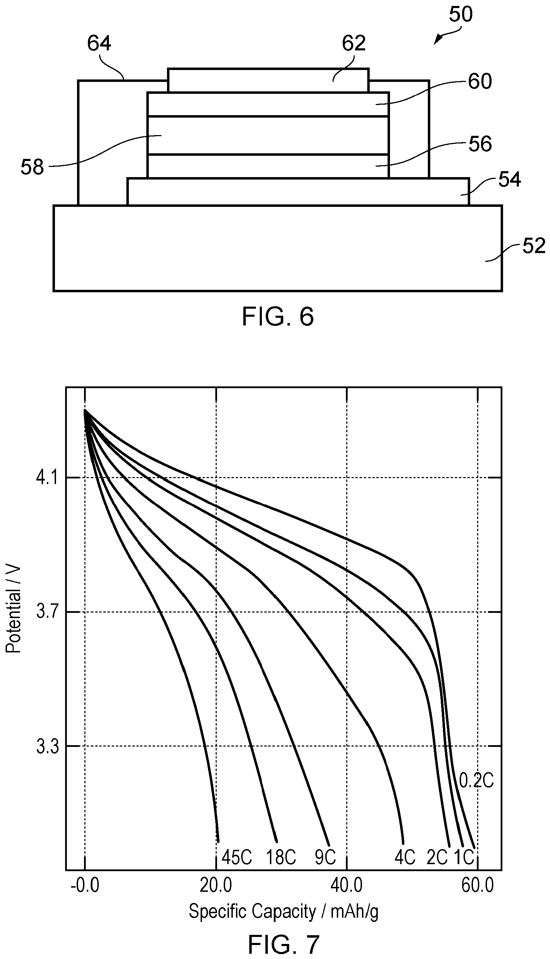

Figure 6 shows a schematic cross-sectional view of an example lithium ion thin film battery or cell 50 of typical structure. Such batteries comprise a series of layers, typically formed by one or more deposition or other fabrication processes. A substrate 52 supports the various layers. In order starting from the substrate these are a cathode current collector 54, a cathode 56, a electrolyte 58, an anode 60 and an anode current collector 62. A protective encapsulation layer 64 is formed over the layers. In other examples the layers may be arranged in the opposite order, with the exception of the encapsulation layer which, if included, will always be the last layer.

To test the capability of thin films deposited according to the invention to function in thin films cells, a half-cell of lithium manganese oxide (LMO) was created by co-depositing lithium, manganese and oxygen at the appropriate ratio from separate vapour sources, using a substrate temperature of 225°C. The conditions used were determined by depositing test samples, the composition of which was determined using laser ablation inductively coupled mass spectrometry (ICPMS) and the rates of the lithium and manganese sources were altered accordingly to obtain optimum conditions for deposition of the desired composition. LMO with a thickness of 300 nm was deposited onto a platinum pad over an area of 2.25 mm², and was assembled into a half cell with 1 M LiPF₆ in EC:DMC = 1:1 as the electrolyte and lithium metal as the counter and reference electrode.

Figure 7 shows discharge curves of the LMO thin films at various rates ranging from 0.1 to 25 mV/s (0.2 to 45 C) in the potential window between 4.3 and 3.0 V vs. Li/Li⁺.

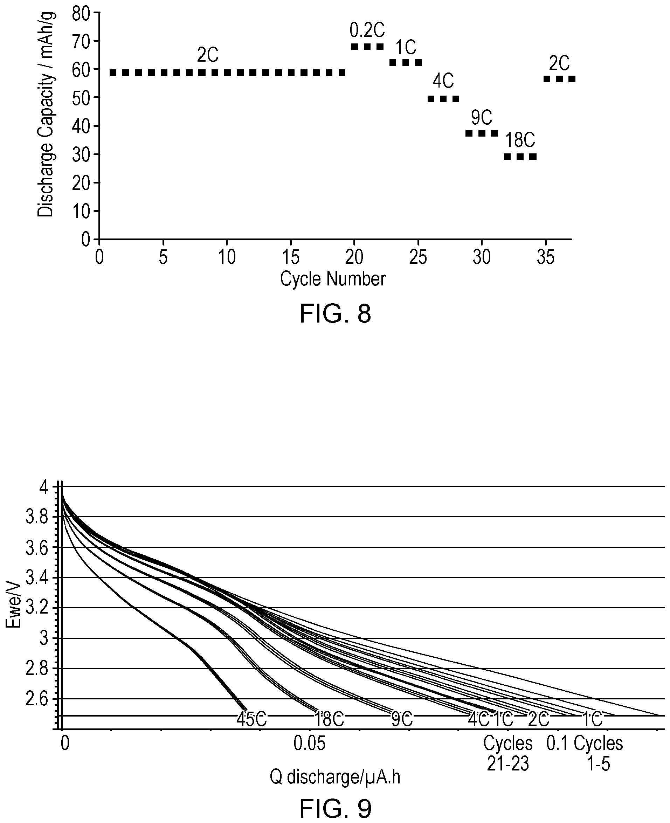

Figure 8 shows measured capacities of the LMO films discharged at various rates from 0.1 to 25 mV/s (0.2 to 45 C) in the potential window between 5.0 and 3.0 V vs. Li/Li⁺.

From these measurements, we observe that the capacity of the LMO material has a discharge capacity of 60 mAh g⁻¹ or 29 µAh cm⁻²µm⁻¹ at a charge and discharge rate of 1 *C*. Charge and discharge times are expressed as C-rates where a 1C-rate corresponds to a complete charge/discharge in 1 hour; an 'n' C-rate will charge/discharge a cell in 1/n hrs. Commonly, batteries are charged and discharged using slow rates (ca. 0.01*C*), and as the rate increases the accessible capacity decreases. In fact, "most commercial cells only use a few percent of their stored energy when charged at rates starting as low as 10 C" (Braun, P.V., Current Opinion in Solid State Materials Science, 16, 4 (2012), 186-198). These results are an improvement over LMO deposited at similar substrate temperatures using other methods. LMO thin films deposited by RF-sputtering at 200°C have been shown to have a discharge capacity of 24 µAh cm⁻² µm⁻¹ (Jayanth et al. Appl Nanosci (2012) 2:401-407) and LMO deposited by PLD at 200°C has been shown to have a discharge capacity of -18 µAh cm⁻² µm⁻¹. (Tang et al. J. Solid State Chemistry 179 (2006) 3831-3838). An experiment was carried out to study the rate capability of the deposited LMO by cycling using cyclic voltammetry between potential limits of 3 and 5 V using sweep rates between 0.1 and 150 mV/s (equivalent to C rates between 0.2 and 270 C). The results are shown in Table 1, as a summary of capacities as a function of sweep rate for LiMn₂O₄ thin films at various rates ranging from 0.1 to 150 mV/s (0.2 to 270 C) in the potential window between 4.3 and 3.0 V *vs.* Li/Li⁺.

**Table 1**

| Rate / mV/s (*C*) | Capacity / mAh/g | Percentage Capacity (cf. 0.2*C*) |
|---|---|---|
| 1 (1.8 *C*) | 57.7 | 85 |
| 0.1 (0.2 *C*) | 67.5 | 100 |
| 0.5 (1 *C*) | 61.8 | 92 |
| 2 (3.6 *C*) | 48.9 | 72 |
| 5 (9 *C*) | 36.7 | 54 |
| 10 (18 *C*) | 28.7 | 43 |
| 1 (1.8 *C*) | 56.1 | 83 |
| 25 (45 *C*) | 20.4 | 30 |
| 50 (90 *C*) | 17.3 | 26 |
| 100 (180 *C*) | 13.8 | 20 |
| 150 (270 *C*) | 12.0 | 18 |

Hence, LMO deposited by methods according to embodiments of the present invention demonstrates a good cycle ability and only moderate loss in capacity when cycled at increased rates, and exhibits negligible capacity loss over 35 cycles, as shown in Figure 8. The mean capacity over cycles 1-19 was observed to be 58.73 mA g⁻¹. Following a further 15 cycles, at rates up to 45 C the capacity of the PVD LMO was observed to only drop to 56.84 mA g⁻¹ (3.2% loss). When cycled at high rates (up to 270 C), LMO deposited by PVD exhibits only moderate losses in capacity; see Table 1. These losses are considerably less than those observed in LMO deposited by other means. For example, Chen et al (Thin Solid Films 544 (2013) 182-185) claim a high rate performance LMO. In this case the LMO exhibits at best only 22% of its initial capacity (at 0.2 C) when cycled at 45 *C*. In a direct comparison, LMO deposited by the current invention retains 30% of its capacity. Being able to access the capacity of the LMO at high rates means that the material is useful for applications requiring short bursts of high power.

Figure 9 shows discharge curves from CC/CV experiments on solid state cells comprising a LMO cathode deposited at a substrate temperature of 225°C in accordance with the invention. The cells were discharged at various rates ranging from 1 to 45 *C* in the potential window between 4.0 and 2.5 V *vs.* Li/Li⁺. The cells had an area of 2.25 mm² and were deposited entirely by physical vapour deposition in ultra-high vacuum, with the LMO cathodes deposited in accordance with the present invention. 300 nm of LMO cathode was deposited directly from lithium, manganese and oxygen sources onto a sapphire substrate coated with 10 nm of TiO₂ and 100 nm of Pt. The temperature of the substrate was held at 225°C throughout the cathode deposition, monitored by an in-situ thermocouple. A solid state electrolyte comprising lithium borosilicate was deposited directly from lithium, boron, silicon and oxygen sources at 225°C to give a thickness of 800 nm. A SnO₂ anode was deposited directly from tin and oxygen sources, once again at 225°C to give a thickness of 10 nm. These depositions were carried out within the same vacuum chamber, one after the other. Physical masks were utilised to define the regions of each layer. The masks were changed between the deposition of the electrolyte and the anode. A nickel current collector was deposited by PVD following the completion of the SnO₂ layer, and after the sample had cooled to room temperature (17°C).

As can be seen from Figure 9, the initial capacity of these cells when cycled at 1 *C* is 0.1 µAh, which is equivalent to 19 µAh cm⁻² µm⁻¹; this shows a significant improvement compared with a previous demonstration of a cell with LMO and SnO₂ electrodes and using a liquid electrolyte, where discharge capacities of less than 10 µAh cm⁻² µm⁻¹ were reported for a balanced cell (Park, Y. J. et al., J. Power Sources, 88, (2000), 250-254). The results demonstrates that the cell can function at high rates, which is necessary for high power applications where short bursts of power are required.

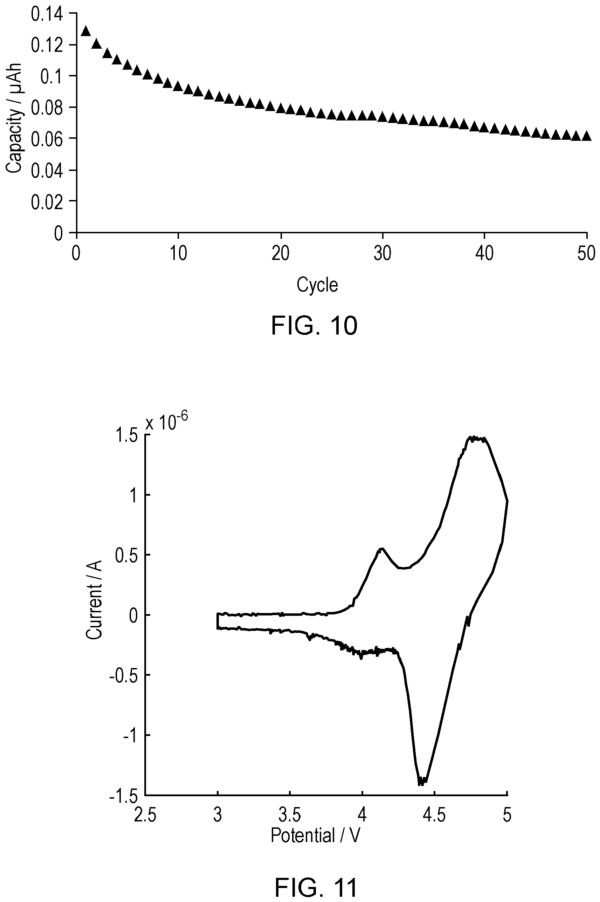

Figure 10 shows further experimental results for these cells, in the form of a plot of discharge capacity over the course of 50 cycles of one cell. The cell was charged and discharged at a rate of 1 *C* between 4.0 and 2.5 V. An initial capacity loss is observed during the first 20 cycles, but after this the capacity retention is reasonably good which demonstrates that a rechargeable cell has been produced.

Although these results are for LMO deposited at 225°C, the data presented in Figure 2 indicate that working cells can also be expected for LMO deposited at other temperatures over the 150°C to 350°C range.

### Further experimental results: LMNO deposited at 350°C

In the same manner as LMO, LMNO deposited according to embodiments of the invention at a substrate temperature of 350°C has been demonstrated to be electrochemically active.

A half cell of lithium manganese nickel oxide (LMNO) was created by using a method according to an embodiment of the invention to co-deposit lithium, manganese, nickel and oxygen at the appropriate ratio, at a substrate temperature of 350°C. An electrochemical array, composed of a silicon/silicon nitride substrate and platinum pads was used as a substrate in this case. The half cell was completed using 1 M LiPF₆ in EC:DMC = 1:1 as the electrolyte and lithium metal as the counter electrode.

Figure 11 shows the results of cyclic voltammetry performed on this cell, over the first cycle. These measurements were carried out at a sweep rate of 1 mV s⁻¹ between 3 and 5V, giving an equivalent charge rate of 1.8 *C*. Peaks can be clearly seen during the charge at 4.1 V and 4.7 V, which indicate the presence of both Mn³⁺ and Ni²⁺ in the films. From this, it can be supposed that an oxygen deficient LMNO had been produced, with the composition LiMn_{1.5}Ni_{0.5}O_{4-δ} (where δ is between 0 and .05).

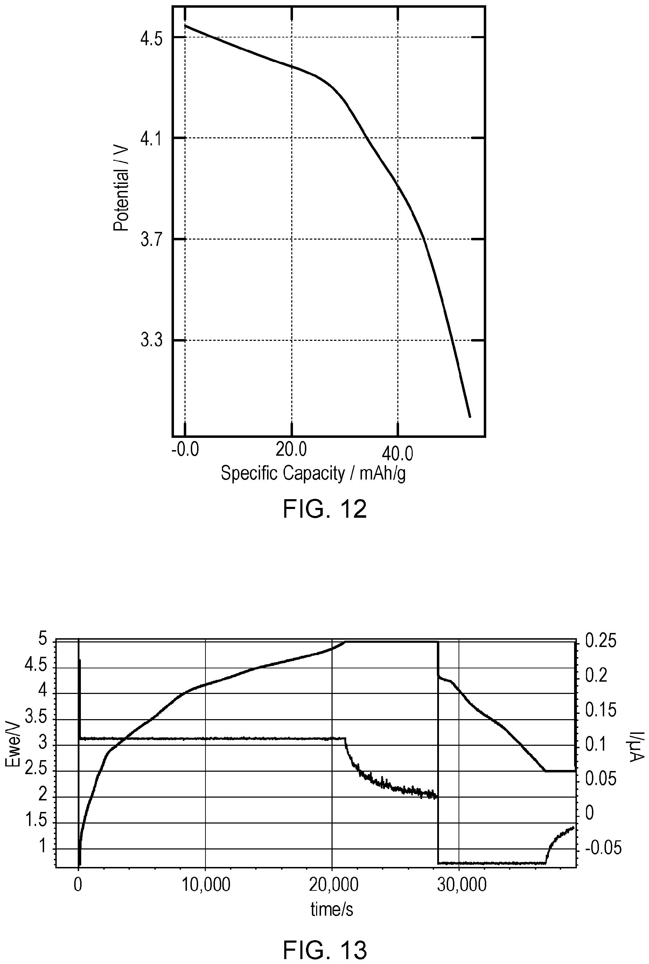

Figure 12 shows the corresponding discharge curve. From this it can be seen that the discharge capacity for this half cell of LMNO vs. Li in liquid electrolyte is 53 mA g⁻¹, which is 36 % of the theoretical capacity for LiMn_{1.5}Ni_{0.5}O₄.

Additionally, a full solid state cell with a LMNO cathode deposited according to an embodiment of the invention at a substrate temperature of 350°C was fabricated and tested. This cell was deposited entirely by physical vapour deposition. The LMNO cathode was deposited directly from lithium, manganese, nickel and oxygen sources onto a sapphire substrate coated with 10 nm of TiO₂ and 100 nm of platinum and held at 350°C throughout the deposition, monitored by an in-situ thermocouple. A solid state electrolyte of lithium borosilicate was deposited directly from lithium, boron, silicon and oxygen sources at 225°C. The substrate was cooled controllably between deposition of the cathode and the electrolyte. A SnO₂ anode was deposited directly from tin and oxygen vapour source, once again at 225°C. These depositions were carried out within the same vacuum chamber, one after the other. Following completion of the SnO₂ layer and once the sample had cooled to room temperature (17°C), a nickel current collector was deposited (by PVD).

Figure 13 shows discharge curves from CC/CV experiments on this cell, in the form of the first cycle, when cycled between 5.0V and 3.0V in a glove box. In this case the initial discharge capacity is as high as 62% of the theoretical capacity of the cathode, and equivalent to 40.9 µAh cm⁻² µm⁻¹. Although the LMNO was deposited at 350°C in this example, the X-ray diffraction measurements of LMNO deposited using this method at substrate temperatures as low as 150°C shows the films to be crystalline. It can therefore be expected that thin film cells containing LMNO deposited at temperatures at and above 150°C could successfully be produced.

So, although these results are for LMNO deposited at 350°C, the data presented in Figure 3 indicate that working cells can also be expected for LMNO deposited at other temperatures over the 150°C to 350°C range.

### Increased deposition rate

The samples described above were deposited at a rate of approximately 0.15 µm/hr (a specific example being a 300 nm thickness film deposited over 118 minutes). Using a modified apparatus, it has been possible to greatly increase the deposition rate. In particular, a different geometry of the components in the deposition apparatus aimed at optimising thin film production and in which the vapour sources are placed closer to the substrate (and also made larger to increase the run time capacity of the apparatus) enables a higher deposition rate.

As an example, LMO films have been deposited at a rate of 0.84 µm/hr, corresponding to the deposition of a 308 nm thickness film deposited over 22 minutes. This is more than five times the rate of the previous examples. Characterisation of these films indicates that they are also of excellent crystalline quality and demonstrate good practical performance.

LMO films were deposited at substrate temperature of 350°C. The same source types as before were used, namely Knudsen cells to provide lithium vapour and manganese vapour, and a plasma source to provide atomic oxygen.

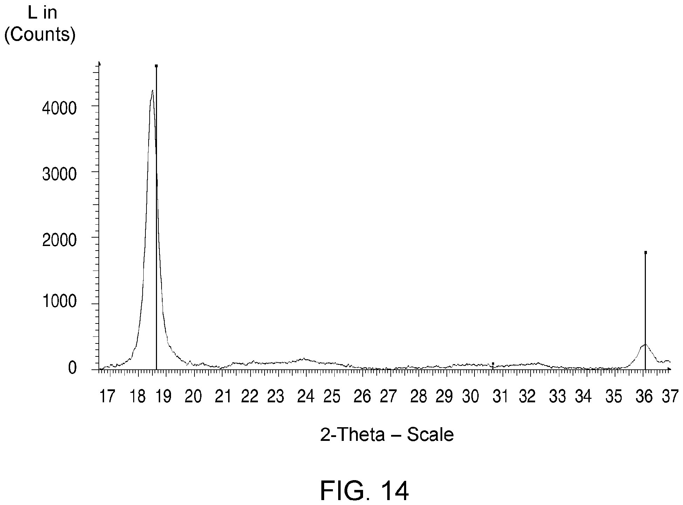

Figure 14 shows the result of an X-ray diffraction measurement made on one of these sample films. The results show the desired crystalline structure, indicated by the peaks at 18.4° and 36°. These peaks are consistent with the expected reflections from LiMn₂O₄ (00-035-0782), with the former arising from the 111 reflection and the latter from the 311 reflection. Comparison with Figure 2, showing X-ray diffraction results from LMO samples deposited at the slower rate, indicates that the faster-deposited samples exhibit less texture (and hence an improved crystallinity), since the 311 reflection is observed, while being absent in the measurements from the slower rate samples.

Determining the full width at half maximum (FWHM) for these peaks provides further insight into the improved crystallisation. The FWHM was calculated to be 0.511°, which can be translated into an approximate crystallite size of 16 nm using the Scherrer equation. This is in reasonable agreement with the crystallite size of 17 nm obtained for the 350°C substrate temperature samples grown at the slower rate (discussed in relation to Figure 2).

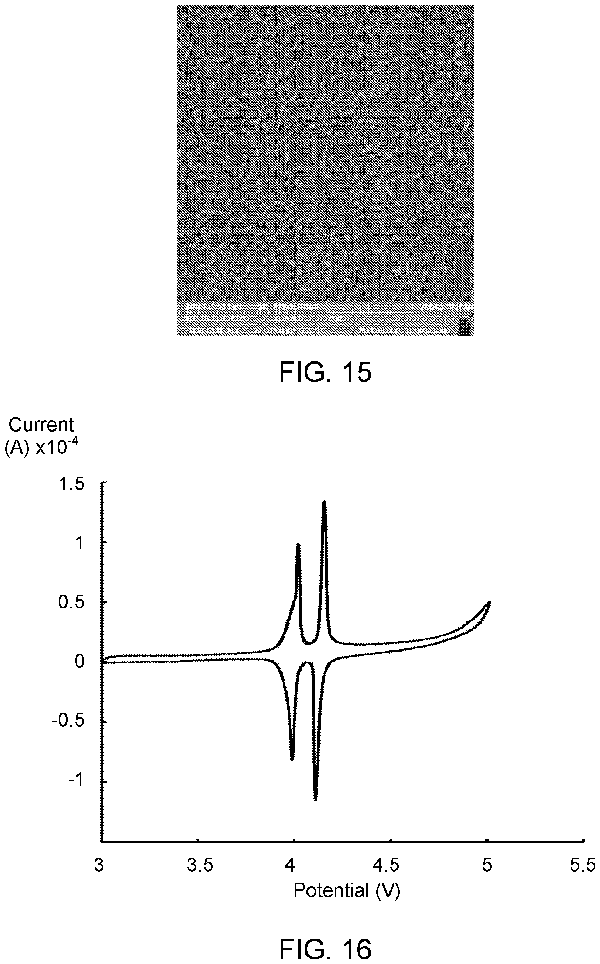

Figure 15 shows a scanning electron microscope (SEM) image (taken at 30 KX magnification) of a high deposition rate LMO sample. Comparison with the SEM images of the low rate LMO samples shown in Figures 4(d) and (e) reveals that more surface features are present in the high rate film. These features are still very small compared with those in samples grown using sputtering (see Figures 4(a), (b) and (c)), however. Typical feature sizes are of the order of 200 nm, which is about five times smaller than those observed in sputtered films. Hence, an increased deposition rate still gives samples of greatly improved surface smoothness compared to films made by conventional techniques.

To demonstrate that the capability of thin films made according to the present invention to function in thin film cells and batteries applies also to increased deposition rates, a half-cell of LMO was created at a deposition rate of 0.84 µm/hr. Lithium, manganese and oxygen were co-deposited at the appropriate ratio from separate vapour sources using a substrate temperature of 350°C. The conditions used were determined by depositing test samples, the composition of which was determined using laser ablation inductively coupled mass spectrometry (ICPMS) and the rates of the lithium and manganese sources were altered accordingly to obtain optimum conditions for deposition of the desired composition. LMO with a thickness of 308 nm was deposited onto a platinum pad over an area of 100 mm², and was assembled into a half cell with 1 M LiPF6 in EC:DMC = 1:1 as the electrolyte and lithium metal as the counter and reference electrode.

Figure 16 shows a graph of cyclic voltammetry performed on this half cell, over the first cycle. Cycling was carried out at 0.5 *C* between 3 and 5 V vs. Li/Li+. From this, one can determine the energy density (discharge capacity) to be 79 mAh/g. This compares well with the corresponding results discussed above for films deposited at slower rates.

Hence, the deposition rate for implementing deposition according to methods of the invention can be altered without detriment to the quality of the crystalline films and their functionality. Increased deposition rates are attractive for practical manufacturing purposes, and further optimisation of apparatus will be able to produce higher rates than the 0.84 µm/hr described herein.

### Temperature

As discussed above, according to the invention, the substrate is heated to between about 150°C and 450°C. The actual temperature selected in practice will depend on various factors. As indicated in the experimental results sections, a higher temperature enhances crystallinity, giving a large crystallite size. So, a temperature towards the top of the range might be preferred. However, the fact that a crystalline material can be also be produced at what is effectively a very much lower temperature (about 150°C) than known annealing temperatures and substrate temperatures makes the lower end of the range attractive if one is interested in reducing energy usage and hence production costs. The fairly wide range of operating temperatures available under the invention is also attractive, since it facilitates matching the substrate temperature to temperatures required for other processing steps in a fabrication process. There is hence a freedom available when selecting operating parameters for implementing the invention, and the temperature can be chosen to best fit with other requirements. A temperature from the lower end of the range, say from 150°C to 250°C, orfrom the middle of the range, say from 200°C to 300°C, or from the top of the range, say from 250°C to 350°C or from 300°C to 450°C might be chosen according to circumstances.

### Further materials

Thus far, the fabrication of crystalline LMO and LMNO has been described. However, the invention is not limited to these materials, and the process of deposition of the component elements directly onto a heated substrate is applicable to the production of other lithium containing transition metal oxides in crystalline form. Any transition metal or metals can be substituted for the manganese and manganese plus nickel embodiments discussed so far. The chemistry of the transition metals is sufficiently similar and predictable across the group that it can be expected that crystalline material will deposit at moderate substrate temperatures using the method of the invention for any lithium-containing transition metal oxide of interest. Materials that are of particular interest for specific applications are LiCoO₂, LiNiO₂, LiCo_{1/3}Ni_{1/3}Mn_{1/3}O₂ (NMC), LiNi_{0.8}Co_{0.15}Al_{0.05}O₂ (NCA) and LiV₃O₈ for use as cathodes, and Li₄Ti₅O₁₂ for use as anodes. These materials may be used for other applications, however, and other lithium containing transition metal oxides are not precluded. Also, lithium containing transition metal oxy-nitrides and nitrogen-doped materials may also be fabricated using methods according to the invention, for which a source of nitrogen is included amongst the vapour sources. A separate nitrogen source may be used, but note that nitrogen may instead be provided by introducing it into a feed of an oxygen plasma source to deliver oxygen and nitrogen combined.

### Substrates

The experimental results presented herein relate to thin films deposited onto titanium oxide and platinum coated sapphire substrates and silicon/silicon nitride substrates with platinum pads. Other substrates may be used if preferred however. Other suitable examples include quartz, silica, glass, sapphire, and metallic substrates including foils, but the skilled person will understand that other substrate materials will also be suitable. Requirements for the substrate are that an appropriate deposition surface is provided and that it can withstand the required heating; otherwise the substrate material can be selected as desired with reference to the application to which the deposited compound is to be put.

Also, the embodiments of the invention are applicable equally to the deposition of the component elements directly onto the substrate surface, and onto one or more layers previously deposited or otherwise fabricated on the substrate. Thus, the invention can be used in the fabrication of various layered thin film structures and devices. Thus, reference in this application to "a substrate" "depositing onto a substrate", "co-depositing onto a substrate" and similar apply equally to "a substrate supporting one or more pre-fabricated layers", "depositing onto a layer or layers previously fabricated on a substrate", "co-depositing onto a layer or layers previously fabricated on a substrate" and the like. The invention applies equally whether or not there are any other layers intervening between the substrate and the crystalline lithium-containing transition metal oxide being deposited.

### Applications

The crystalline nature of the materials able to be deposited in accordance with invention, combined with the smooth surface morphology and good charge and discharge capacities, make the materials well-suited for use as electrodes (both cathodes and anodes) in thin film batteries, and this is expected to be a major application. The methods of the invention are readily adaptable to the manufacture of battery components within devices such as sensors, photovoltaic cells and integrated circuits and the like. However, the materials are not limited to use as electrodes, and the method may be used to deposit layers of the crystalline lithium-containing metal oxide compounds for any other applications. Possible examples include sensors, lithium separators, interface modifiers and ion conductors within electrochromic devices.

### REFERENCES

[1] Tang, S.B., et al., J. Solid State Chem., 179(12), (2006), 3831-3838
[2] Julien, C.M. and G.A. Nazri, Chapter 4. Materials for electrolyte: Thin Films, in Solid State Batteries: Materials Design and Optimization (1994)
[3] Thornton, J.A. and J.E. Greene, Sputter Deposition Processes, in Handbook of Deposition Technologies for films and coatings, R.F. Bunshah, Editor 1994, Noyes Publications
[4] Wang et al. Electrochimica Acta 102 (2013) 416-422
[5] Singh et al. J. Power Sources 97-98 (2001), 826-831
[6] Jayanth et al. Appl Nanosci. (2012) 2:401-407
[7] WO 2013/011326
[8] WO 2013/011327
[9] Baggetto et al., J Power Sources 211 (2012) 108-118
[10] Zhong, Q., et al., J. Electrochem. Soc., (1997), 144(1), 205-213
[11] Bates et al. Synthesis, Journal of Solid State Chemistry (1995), 115 (2), 313-323
[12] WO 2001/73883
[13] EP 1,305,838
[14] Guerin, S; Hayden, B. E., J. Comb. Chem., 2006, 8, 66
[15] WO 2005/035820
[16] Chen et al., Thin Solid Films 544 (2013) 182-185
[17] Park, Y. J. et al., J. Power Sources, 88, (2000), 250-254

## Claims

1. A vapour deposition method for preparing a crystalline lithium-containing transition metal oxide compound, the method comprising:
providing a vapour source of each component element of the compound, wherein the vapour sources comprise at least a source of lithium, a source of oxygen, and a source or sources of one or more transition metals;
wherein the source or sources of one or more transition metals comprises a source of each of one or more of scandium, titanium, vanadium, chromium, manganese, iron, cobalt, nickel, copper, zinc, yttrium, zirconium, niobium, molybdenum, technetium, ruthenium, rhodium, palladium, silver, lutetium and hafnium;
the method further comprising the steps of:
heating a substrate to between 150°C and 450°C; and
co-depositing each component element from its respective vapour source onto the heated substrate at a controlled rate of deposition wherein the component elements react on the substrate to form the crystalline compound,
wherein either:
the vapour source of oxygen comprises an ozone source; or
the vapour source of oxygen comprises a plasma source, and oxygen provided by the source of oxygen is delivered to the heated substrate as plasma-phase oxygen comprising a flux of oxygen atoms, radicals, and ions, for co-deposition and reaction with the other component elements.

2. A vapour deposition method according to claim 1, comprising heating the substrate to between 150°C and 250°C.

3. A vapour deposition method according to claim 1, comprising heating the substrate to between 250°C and 350°C.

4. A vapour deposition method according to claim 1, comprising heating the substrate to between 200°C and 300°C.

5. A vapour deposition method according to claim 1, comprising heating the substrate to between 300°C and 450°C.

6. A vapour deposition method according to any one of the preceding claims, in which the source or sources of one or more transition metals comprises a source of manganese, and the crystalline compound is lithium manganese oxide.

7. A vapour deposition method according to any one of claims 1 to 5, in which the source or sources of one or more transition metals comprise a source of manganese and a source of nickel, and the crystalline compound is lithium manganese nickel oxide.

8. A vapour deposition method according to any one of claims 1 to 5, in which the source or sources of one or more transition metals comprises a source of each of one or more of cobalt, nickel, manganese, iron, vanadium, molybdenum, titanium, copper and zinc.

9. A vapour deposition method according to claim 1, in which the crystalline compound is LiCoO₂ or LiNiO₂ or LiCo_{1/3}Ni_{1/3}Mn_{1/3}O₂ or LiNi_{0.8}Co_{0.15}Al_{0.05}O₃ or LiV₃O₈ or Li₄Ti₅O₁₂.

10. A vapour deposition method according to any one of claims 1 to 5, in which the source or sources of one or more transition metals comprises a source of cobalt, and the crystalline compound is lithium cobalt oxide, LiCoO₂.

11. A vapour deposition method according to any one of claims 1 to 5, or 8, in which the vapour sources further comprise a source of nitrogen.

12. A method of making a battery, comprising depositing an electrode of the battery as a layer of a crystalline lithium-containing transition metal oxide compound using a vapour deposition method according to any one of claims 1 to 11.

13. A method according to claim 12, in which the electrode is a cathode.

14. A method according to claim 12, in which the electrode is an anode.

## Patentansprüche

1. Ein Dampfabscheidungsverfahren zur Herstellung einer kristallinen lithiumhaltigen Übergangsmetalloxidverbindung, wobei das Verfahren Folgendes beinhaltet:
Bereitstellen einer Dampfquelle von jedem bestandteilbildenden Element der Verbindung, wobei die Dampfquellen mindestens eine Quelle von Lithium, eine Quelle von Sauerstoff und eine Quelle oder Quellen von einem oder mehreren Übergangsmetallen beinhalten;
wobei die Quelle oder Quellen von einem oder mehreren Übergangsmetallen eine Quelle von jedem von einem oder mehreren von Scandium, Titan, Vanadium, Chrom, Mangan, Eisen, Cobalt, Nickel, Kupfer, Zink, Yttrium, Zirconium, Niob, Molybdän, Technetium, Ruthenium, Rhodium, Palladium, Silber, Lutetium und Hafnium beinhalten; wobei das Verfahren ferner die folgenden Schritte beinhaltet:
Erwärmen eines Substrats auf zwischen 150 °C und 450 °C; und
Ko-Abscheiden jedes bestandteilbildenden Elements mit einer gesteuerten Abscheiderate aus seiner jeweiligen Dampfquelle auf das erwärmte Substrat, wobei die bestandteilbildenden Elemente auf dem Substrat reagieren, um die kristalline Verbindung zu bilden,
wobei entweder:
die Dampfquelle von Sauerstoff eine Ozonquelle beinhaltet; oder
die Dampfquelle von Sauerstoff eine Plasmaquelle beinhaltet und Sauerstoff, der durch die Quelle von Sauerstoff bereitgestellt wird, dem erwärmten Substrat als Plasmaphasensauerstoff, der einen Fluss von Sauerstoffatomen, -radikalen und -ionen beinhaltet, zur Ko-Abscheidung und Reaktion mit den anderen bestandteilbildenden Elementen zugeführt wird.

2. Dampfabscheidungsverfahren gemäß Anspruch 1, das das Erwärmen des Substrats auf zwischen 150 °C und 250 °C beinhaltet.

3. Dampfabscheidungsverfahren gemäß Anspruch 1, das das Erwärmen des Substrats auf zwischen 250 °C und 350 °C beinhaltet.

4. Dampfabscheidungsverfahren gemäß Anspruch 1, das das Erwärmen des Substrats auf zwischen 200 °C und 300 °C beinhaltet.

5. Dampfabscheidungsverfahren gemäß Anspruch 1, das das Erwärmen des Substrats auf zwischen 300 °C und 450 °C beinhaltet.

6. Dampfabscheidungsverfahren gemäß einem der vorhergehenden Ansprüche, wobei die Quelle oder Quellen von einem oder mehreren Übergangsmetallen eine Quelle von Mangan beinhalten und die kristalline Verbindung Lithiummanganoxid ist.

7. Dampfabscheidungsverfahren gemäß einem der Ansprüche 1 bis 5, wobei die Quelle oder Quellen von einem oder mehreren Übergangsmetallen eine Quelle von Mangan und eine Quelle von Nickel beinhalten und die kristalline Verbindung Lithiummangannickeloxid ist.

8. Dampfabscheidungsverfahren gemäß einem der Ansprüche 1 bis 5, wobei die Quelle oder Quellen von einem oder mehreren Übergangsmetallen eine Quelle von jedem von einem oder mehreren von Cobalt, Nickel, Mangan, Eisen, Vanadium, Molybdän, Titan, Kupfer und Zink beinhalten.

9. Dampfabscheidungsverfahren gemäß Anspruch 1, wobei die kristalline Verbindung LiCoO₂ oder LiNiO₂ oder LiCo_{1/3}Ni_{1/3}Mn_{1/3}O₂ oder LiNi_{0,8}Co_{0,15}Al_{0,05}O₂ oder LiV₃O₈ oder Li₄Ti₅O₁₂ ist.

10. Dampfabscheidungsverfahren gemäß einem der Ansprüche 1 bis 5, wobei die Quelle oder Quellen von einem oder mehreren Übergangsmetallen eine Quelle von Cobalt beinhalten und die kristalline Verbindung Lithiumcobaltoxid, LiCoO₂, ist.

11. Dampfabscheidungsverfahren gemäß einem der Ansprüche 1 bis 5 oder 8, wobei die Dampfquellen ferner eine Quelle von Stickstoff beinhalten.

12. Ein Verfahren zum Fertigen einer Batterie, das das Abscheiden einer Elektrode der Batterie als eine Schicht einer kristallinen lithiumhaltigen Übergangsmetalloxidverbindung unter Verwendung eines Dampfabscheidungsverfahrens gemäß einem der Ansprüche 1 bis 11 beinhaltet.

13. Verfahren gemäß Anspruch 12, wobei die Elektrode eine Kathode ist.

14. Verfahren gemäß Anspruch 12, wobei die Elektrode eine Anode ist.

## Revendications

1. Un procédé de dépôt en phase vapeur pour préparer un composé cristallin d'oxyde de métal de transition contenant du lithium, le procédé comprenant :
le fait de fournir une source de vapeur de chaque élément constitutif du composé, où les sources de vapeur comprennent au moins une source de lithium, une source d'oxygène, et une source ou des sources d'un ou de plusieurs métaux de transition ;
où la source ou les sources d'un ou de plusieurs métaux de transition comprennent une source de chacun d'un ou de plusieurs éléments parmi le scandium, le titane, le vanadium, le chrome, le manganèse, le fer, le cobalt, le nickel, le cuivre, le zinc, l'yttrium, le zirconium, le niobium, le molybdène, le technétium, le ruthénium, le rhodium, le palladium, l'argent, le lutécium et le hafnium ;
le procédé comprenant en outre les étapes consistant à :
chauffer un substrat à une température comprise entre 150 °C et 450 °C ; et
codéposer chaque élément constitutif provenant de sa source de vapeur respective sur le substrat chauffé à un taux de dépôt contrôlé, où les éléments constitutifs réagissent sur le substrat afin de former le composé cristallin,
où soit :
la source de vapeur d'oxygène comprend une source d'ozone ; soit
la source de vapeur d'oxygène comprend une source de plasma, et l'oxygène fourni par la source d'oxygène est distribué au substrat chauffé sous la forme d'oxygène en phase plasma comprenant un flux d'atomes, de radicaux, et d'ions d'oxygène, pour le codépôt et la réaction avec les autres éléments constitutifs.

2. Un procédé de dépôt en phase vapeur selon la revendication 1, comprenant le fait de chauffer le substrat à une température comprise entre 150 °C et 250 °C.

3. Un procédé de dépôt en phase vapeur selon la revendication 1, comprenant le fait de chauffer le substrat à une température comprise entre 250 °C et 350 °C.

4. Un procédé de dépôt en phase vapeur selon la revendication 1, comprenant le fait de chauffer le substrat à une température comprise entre 200 °C et 300 °C.

5. Un procédé de dépôt en phase vapeur selon la revendication 1, comprenant le fait de chauffer le substrat à une température comprise entre 300 °C et 450 °C.

6. Un procédé de dépôt en phase vapeur selon n'importe laquelle des revendications précédentes, dans lequel la source ou les sources d'un ou de plusieurs métaux de transition comprennent une source de manganèse, et le composé cristallin est l'oxyde de manganèse-lithium.

7. Un procédé de dépôt en phase vapeur selon n'importe laquelle des revendications 1 à 5, dans lequel la source ou les sources d'un ou de plusieurs métaux de transition comprennent une source de manganèse et une source de nickel, et le composé cristallin est l'oxyde de nickel-manganèse- lithium.

8. Un procédé de dépôt en phase vapeur selon n'importe laquelle des revendications 1 à 5, dans lequel la source ou les sources d'un ou de plusieurs métaux de transition comprennent une source de chacun d'un ou de plusieurs éléments parmi le cobalt, le nickel, le manganèse, le fer, le vanadium, le molybdène, le titane, le cuivre et le zinc.

9. Un procédé de dépôt en phase vapeur selon la revendication 1, dans lequel le composé cristallin est LiCoO₂ ou LiNiO₂ ou LiCo_{1/3}Ni_{1/3}Mn_{1/3}O₂ ou LiNi_{0,8}Co_{0,15}Al_{0,05}O₂ ou LiV₃O₈ ou Li₄Ti₅O₁₂.

10. Un procédé de dépôt en phase vapeur selon n'importe laquelle des revendications 1 à 5, dans lequel la source ou les sources d'un ou de plusieurs métaux de transition comprennent une source de cobalt, et le composé cristallin est l'oxyde de cobalt-lithium, LiCoO₂.

11. Un procédé de dépôt en phase vapeur selon n'importe laquelle des revendications 1 à 5, ou de la revendication 8, dans lequel les sources de vapeur comprennent en outre une source d'azote.

12. Un procédé de fabrication d'une batterie, comprenant le fait de déposer une électrode de la batterie sous la forme d'une couche d'un composé cristallin d'oxyde de métal de transition contenant du lithium à l'aide d'un procédé de dépôt en phase vapeur selon n'importe laquelle des revendications 1 à 11.

13. Un procédé selon la revendication 12, dans lequel l'électrode est une cathode.

14. Un procédé selon la revendication 12, dans lequel l'électrode est une anode.
